# EUROPEAN PATENT APPLICATION

(11) **EP 2 608 083 A1**
(43) Date of publication of application: **26.06.2013**
(21) Application number: 11194467.4
(22) Date of filing: 20.12.2011
(51) Int. Cl.: G06F 17/50

(54) **Method and device for configuring plural automatic provers**

(71) Applicant: Mitsubishi Electric R&D Centre Europe B.V., 1119 NS Schiphol Rijk (NL); Mitsubishi Electric Corporation, Chiyoda-ku Tokyo 100-8310 (JP)
(72) Inventor: Mentre, David, 35708 Rennes Cedex 7 (FR)
(74) Representative: Maillet, Alain

(57) **Abstract**

For configuring plural automatic provers for proving the correctness of plural proof obligations, a device performs a first attempt to obtain at least one proof for at least one proof obligation with the automatic provers within a first processing limit. The device selects, for each automatic prover, at least one proof obligation to be processed by said automatic prover, on the basis of a result of the first attempt with the automatic provers. The device performs a second attempt to obtain at least one proof for the selected at least one proof obligation with the respective automatic provers within a second processing limit.

## Description

The present invention generally relates to automatically proving the correctness of a software or firmware program model.

Formal methods are techniques for demonstrating, using mathematical logic, the correctness of software programs compared to a given specification. Formal methods allow providing a confidence level in the bug-free character of software programs. Such formal methods are also applicable to firmware design, such as in VHDL (*VHSIC - Very-High-Speed Integrated Circuits - Hardware Description Language)* programming.

The "B Method" is a formal method of software development to create a model of a software program. The document *"*The B-Book, Assigning Programs to Meanings", by Jean-Raymond Abrial, 1996, details the "B Method" approach. The behaviour of the created model can be proved using an automatic prover, and even using plural automatic provers.

Proof obligations can also be automatically be proved by using SMT (*Satisfiability Modulo Theory)* provers.

It means that proof obligations can be proved using a plurality of automatic provers. Using plural automatic provers on a same set of proof obligations allows increasing the confidence in the reliability of the software program, when said automatic provers obtain the same results.

However, especially for large or complex software programs, the process performed by such automatic provers is time consuming.

It is desirable to overcome the aforementioned problems and drawbacks of the state of the art.

In particular, it is desirable to provide a solution that allows reducing the processing resources necessary to prove the correctness of software or firmware programs above a given confidence level.

More particularly, it is desirable to provide a solution that allows reducing the processing time necessary to prove the correctness of software or firmware programs above a given confidence level.

To that end, the present invention concerns a method for configuring plural automatic provers for proving the correctness of plural proof obligations, the method being implemented by a device and comprising: performing a first attempt to obtain at least one proof for at least one proof obligation with the automatic provers within a first processing limit; selecting, for each automatic prover, at least one proof obligation to be processed by said automatic prover, on the basis of a result of the first attempt with the automatic provers; and performing a second attempt to obtain at least one proof for the selected at least one proof obligation with the respective automatic provers within a second processing limit.

Thus, by selecting proof obligation to be processed for each automatic prover on the basis of a result of the first attempt performed with all the automatic provers, the proving context may be reduced and the necessary resources for proving the proof obligations are reduced.

According to a particular feature, said second processing limit is greater than the first processing limit.

Thus, by reattempting the proving process with a greater limit, such as a longer timeout, each proof obligation that has not been proved with the automatic provers within the first processing limit has more chances to be proved.

According to a particular feature, said plural proof obligations being provided in sequence, selecting comprises: selecting a second proof obligation for an automatic prover having obtained a proof for a first proof obligation, the second proof obligation being following in said sequence the first proof obligation.

Thus, when the automatic provers accept one proof obligation at a time, each automatic prover may take benefit of proofs already obtained with other automatic provers and therefore switch to another proof obligation although it hasn't itself proved the proof obligation.

According to a particular feature, a proof obligations description being input to each automatic prover, each proof obligations description describing each proof obligation to be proved by the automatic prover, selecting comprises: removing, from at least one proof obligations description, each proof obligation that has been proved with the automatic provers during the first attempt.

Thus, all automatic provers take benefit of the fact that at least one other automatic prover has proved at least one proof obligation, so that the automatic provers that have not yet proved the proof obligations don't have to do it and its proving context is reduced.

According to a particular feature, the method comprises associating a confidence level with each proof obligation that has been proved during the first attempt, and in that selecting comprises selecting each proof obligation associated with a confidence level below than a predefined threshold.

Thus, the confidence level in a proof for a corresponding proof obligation may be increased by reattempting to obtain the proofs that are below the predefined threshold.

According to a particular feature, said confidence level is determined on the basis of a number of automatic provers having proved the proof obligation.

Thus, the confidence level in a proof for a corresponding proof obligation can be increased by the diversity of the used automatic provers, for instance because some automatic provers have been developed by different people using different technologies and thus the probability of having twice the same error in two automatic provers is reduced.

According to a particular feature, said confidence level is determined on the basis of an identification of automatic provers having proved the proof obligation.

Thus, the confidence level in a proof for a corresponding proof obligation can be increased by the intrinsic quality of a known prover, for instance because some automatic provers have received a certification label, and the confidence level may reflect that a proof obtained with at least one certified automatic prover is more reliable than a proof obtained with automatic provers that are not certified.

According to a particular feature, a proof obligations description being input to each automatic prover, each proof obligations description describing each proof obligation to be proved by the automatic prover, selecting comprises: removing each proof obligation that has been proved with the automatic provers during the first attempt from each proof obligations description to be input to an automatic prover having proved said proof obligation during the first attempt; and removing each proof obligation that is associated with a confidence level above said predefined threshold from each proof obligations description.

Thus, all automatic provers take benefit of the fact that at least one other automatic prover has proved at least one proof obligation above the predefined threshold of confidence level, so that the automatic provers that have not yet proved the proof obligations don't have to do it. The confidence level in the proving result is therefore increased and the necessary resources for proving the proof obligations are reduced.

According to a particular feature, a proof obligations description being input to each automatic prover, it comprises beforehand spreading, according to a predefined maximum number of proof obligations per proof obligations description, the proof obligations among plural proof obligations descriptions to be input to each automatic prover.

Thus, by limiting the proof obligation context input to each automatic prover, the time duration of the overall proving process is reduced.

According to a particular feature, said processing limits are processing timeouts.

Thus, the processing limits are easily handled by a human user or automatically controlled.

According to a particular feature, said processing limits are maximum numbers of proving steps or maximum amount of processing resources.

Thus, the processing limits are easily automatically controlled.

The present invention also concerns a device for configuring plural automatic provers for proving the correctness of plural proof obligations, comprising: means for performing a first attempt to obtain at least one proof for at least one proof obligation with the automatic provers within a first processing limit; means for selecting, for each automatic prover, at least one proof obligation to be processed by said automatic prover, on the basis of a result of the first attempt with the automatic provers; and means for performing a second attempt to obtain at least one proof for the selected at least one proof obligation with the respective automatic provers within a second processing limit.

The present invention also concerns a computer program that can be downloaded from a communication network and/or stored on a medium that can be read by a computer and run by a processor. This computer program comprises instructions for implementing the aforementioned method in any one of its various embodiments, when said program is run by the processor.

The present invention also concerns an information storage means, storing a computer program comprising a set of instructions that can be run by a processor for implementing the aforementioned method in any one of its various embodiments, when the stored information is read by a computer and run by a processor.

Since the features and advantages related to the device and to the computer program are identical to those already mentioned with regard to the corresponding aforementioned method, they are not repeated here.

The characteristics of the invention will emerge more clearly from a reading of the following description of an example of embodiment, said description being produced with reference to the accompanying drawings, among which:
Fig. 1 schematically represents a verification chain in which the present invention may be implemented;
Fig. 2 schematically represents a hardware platform that may implement the verification chain;
Fig. 3 schematically represents an algorithm for configuring at least one automatic prover;
Fig. 4 schematically represents an algorithm for generating proof obligations descriptions;
Fig. 5 schematically represents a plurality of proof obligations descriptions generated from a single proof obligations description.

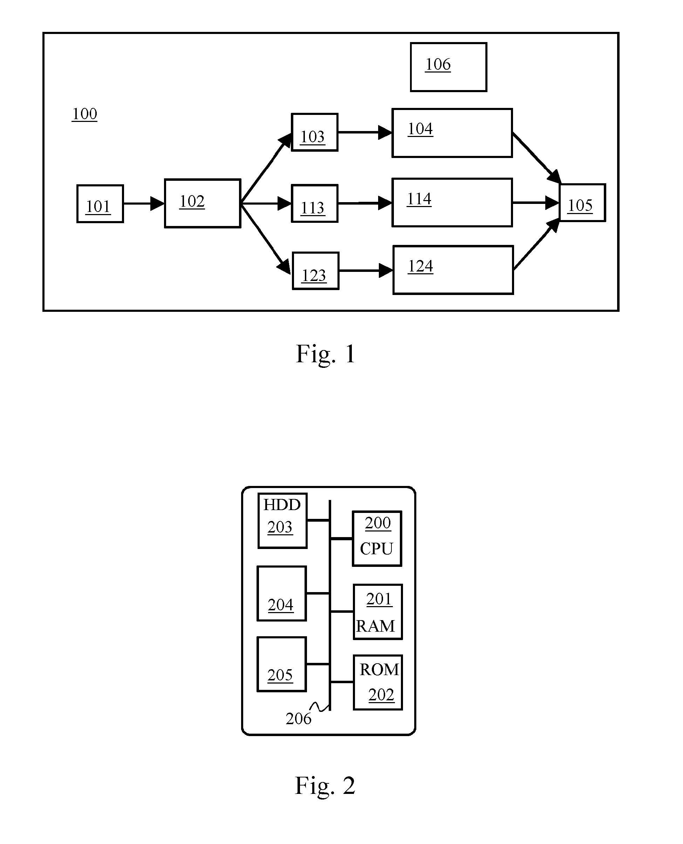

**Fig. 1** schematically represents a verification chain 100 in which the present invention may be implemented.

The verification chain 100 comprises a proof obligations description input 101 adapted to receive a description of a software or firmware program to be verified. The proof obligations description input 101 may be a register or a memory zone adapted to receive, or store, the proof obligations description. The proof obligations description input 101 may be a file, or a pointer to such file, comprising the description of the software or firmware program to be verified. The proof obligations description input 101 is adapted to receive proof obligations descriptions. Each proof obligations description comprises at least one proof obligation. A proof obligation is a logic expression which needs to be proved correct. The proof obligations description may further comprise definitions of formulas and enumerated sets, allowing factorising the expressions recurrently present in the proof obligations definition and simplifying the description of the proof obligations themselves. Each enumerated set is defined as a group of elements than can be used in a formula. The generation of the proof obligations is performed according to the "B Method", as detailed in appendices E and F of the document *"*The B-Book, Assigning Programs to Meanings", by Jean-Raymond Abrial, 1996.

In a variant, the verification chain comprises a model input 101 adapted to receive a description of the software or firmware program in the form of a model, for instance according to the "B Method". Other model definition methods may be used, such as Z notation, VDM (*Vienna Development Method),* SPIN developed at Bell Labs, or ACL2 *(A Computational Logic for Applicative Common Lisp),* to name a few. The model according to the "B Method" is a set of machines, in which some assertions need to be proved, as detailed in chapters 4 and 7 of the document *"*The B-Book, Assigning Programs to Meanings", by Jean-Raymond Abrial, 1996.

The verification chain 100 further comprises a description analysis unit 102 adapted to analyse the description obtained via the proof obligations description input 101. The description analysis unit 102 generates a set of descriptions, the descriptions having respective formats adapted to be processed by respective automatic provers 104, 114, 124. The descriptions are stored in respective description outputs 103, 113, 123. The description outputs 103, 113, 123 may be registers or memory zones adapted to receive, or store, the descriptions generated by the description analysis unit 102. The description outputs 103, 113, 123 may be files, or pointers to such files, comprising the descriptions. The automatic provers 104, 114, 124 are for instance SMT provers, such as a CVC3 prover, an Alt-Ergo prover and a Z3 prover. The automatic provers 104, 114, 124 automatically generate proofs that are stored in a proofs output 105. The proofs output 105 may be a register or a memory zone adapted to receive, or store, the proofs. The proofs output 105 may be a file, or a pointer to such file, comprising the proofs.

In another embodiment, the proof obligations description input 101 is directly connected to the automatic provers 104, 114, 124.

In an illustrative embodiment, the verification chain 100 corresponds to the Why3 platform developed by the French institute INRIA.

The verification chain further comprises a control unit 106. The control unit 106 is adapted to configure the automatic provers 104, 114, 124. Each automatic prover 104, 114, 124 is adapted to attempt to obtain the proofs within a configurable processing limit, such as a processing timeout, a set of processing resources or a maximum number of proving steps. The control unit 106 is adapted to determine the processing limit and to configure each automatic prover accordingly. Each automatic prover stops the proving process when the configured processing limit is reached. The automatic provers may not be capable of stopping the proving process on their own; in this case, the control unit 106 is configured to stop the automatic provers when the considered processing timeout is reached, or when an amount of memory and/or CPU resources is reached.

The control unit 106 is adapted to perform a first attempt to obtain at least one proof for at least one proof obligation with the automatic provers 104, 114, 124 within a first processing limit. The control unit 106 is further adapted to select, for each automatic prover 104, 114, 124, at least one proof obligation to be processed by said automatic prover, on the basis of a result of the first attempt with the automatic provers 104, 114, 124. The control unit 106 is further adapted to perform a second attempt to obtain at least one proof for the selected at least one proof obligation with the respective automatic provers within a second processing limit.

In a first embodiment, the control unit 106 is adapted to set a first processing limit for the automatic provers 104, 114, 124 to process the proof obligations. The control unit 106 is further adapted to check the proofs obtained with the set first processing limit and to set a second processing limit, greater than the first processing limit, for the automatic provers 104, 114, 124 to process remaining proof obligations. The processing limits are for instance processing timeouts, and the second processing timeout is longer than the first processing timeout.

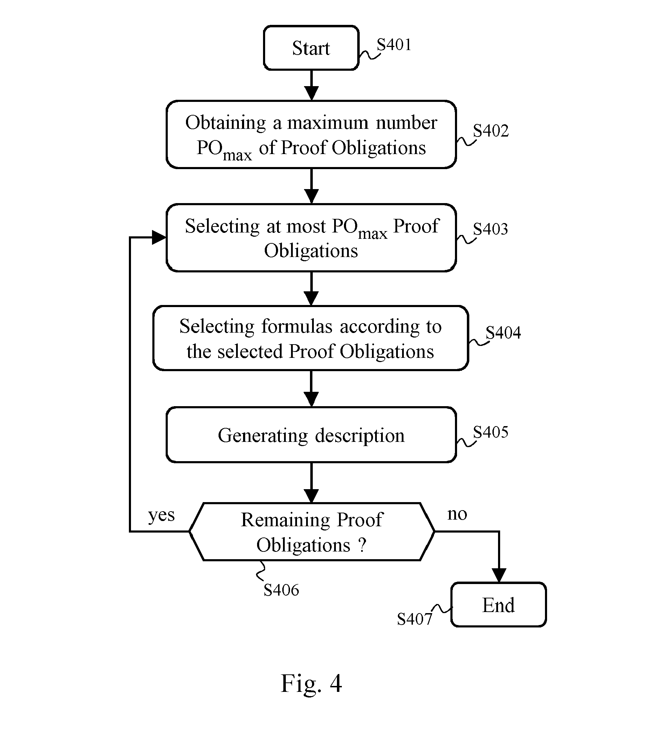

In a second embodiment, the proof obligations are provided in sequence, and the control unit 106 or the description analysis unit 102 is adapted to select a second proof obligation for an automatic prover having obtained a proof for a first proof obligation during the first attempt, the second proof obligation being following in said sequence the first proof obligation. In this case, each automatic prover 104, 114, 124 accepts one proof obligation at a time. For instance, the proof obligations may be separated from each other using the algorithm detailed hereafter with regard to Fig. 4, considering that a maximum number *POₘₐₓ* of proof obligations per proof obligations description is equal to 1. Each automatic prover 104, 114, 124 that hasn't obtained itself a proof switches to the next proof obligation in sequence, once the result of the first attempt allows considering said proof is obtained above a given confidence level. Furthermore, each automatic prover having obtained the proof during the first attempt switches to the next proof obligation in sequence. For instance, the proof has been obtained by at least one automatic prover or by at least a number of automatic provers above a given threshold.

In a third embodiment, a proof obligations description is input to each automatic prover 104, 114, 124, each proof obligations description describing each proof obligation to be proved by the automatic prover. The control unit 106 is adapted to remove, from at least one proof obligations description, each proof obligation that has been proved with the automatic provers during the first attempt. In this case, each automatic prover 104, 114, 124 accepts one or more proof obligation at a time. Once a proof obligation is considered to be proved above a given confidence level, the proof obligation is removed from any description inputted to the automatic provers 104, 114, 124. Furthermore, the proof obligation is removed from the description inputted to each automatic prover having obtained the proof during the first attempt. The proving context of each automatic prover is thus simplified.

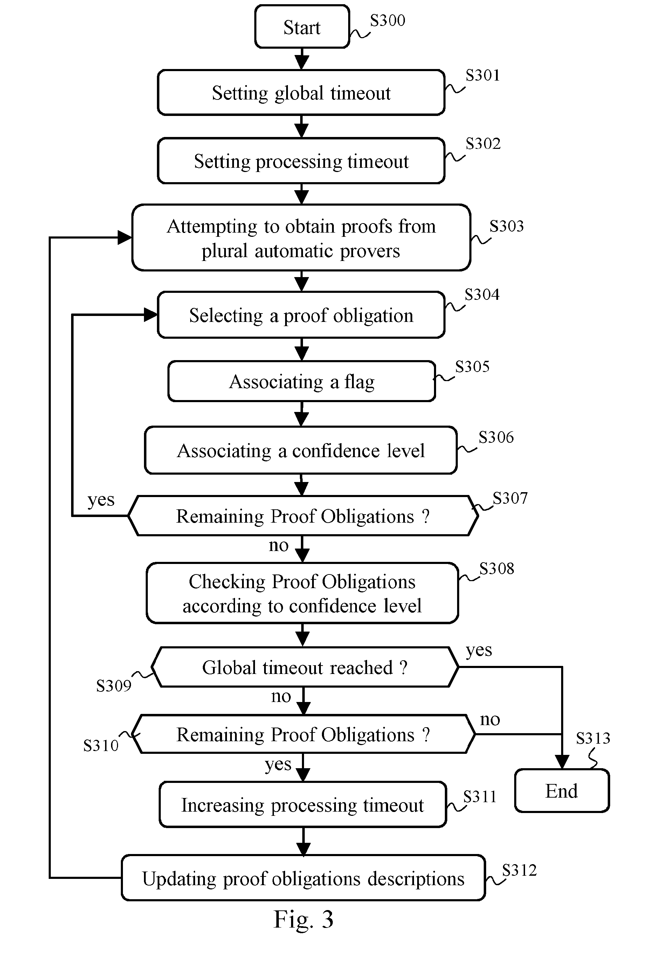

Further details are provided hereafter with regard to Fig. 3.

It can be noticed that each automatic prover may have a distinct processing limit during an attempt to obtain proofs with said automatic provers.

In a particular embodiment, applicable in the context of the first to third embodiments mentioned here above, the control unit 106 is adapted to reiterate the proving process for proof obligations that were not yet proved and for proof obligations that were proved by less than a predefined number of automatic provers. For instance, the processing device reiterates the proving process for proof obligations that were not yet proved and for proof obligations that were proved by only one automatic prover.

In another particular embodiment, applicable in the context of the first to third embodiments mentioned here above, the control unit 106 is adapted to associate a confidence level with each proof obligation as a function of whether the proof obligation has been proved by at least one automatic prover. The confidence level may be in addition determined on the basis of an indication of how many provers have proved the proof obligation. The confidence level may be further determined on the basis of a list of automatic provers having proved the proof obligation. Indeed, some automatic provers may be more reliable than others, for instance because some automatic provers have received a certification label, and the confidence level may reflect that a proof obtained with at least one certified automatic prover is more reliable than a proof obtained with automatic provers that are not certified. Then, the control unit 106 is adapted to reiterate the proving process for proof obligations that were not yet proved and for proof obligations that were proved but with a confidence level below a predefined threshold.

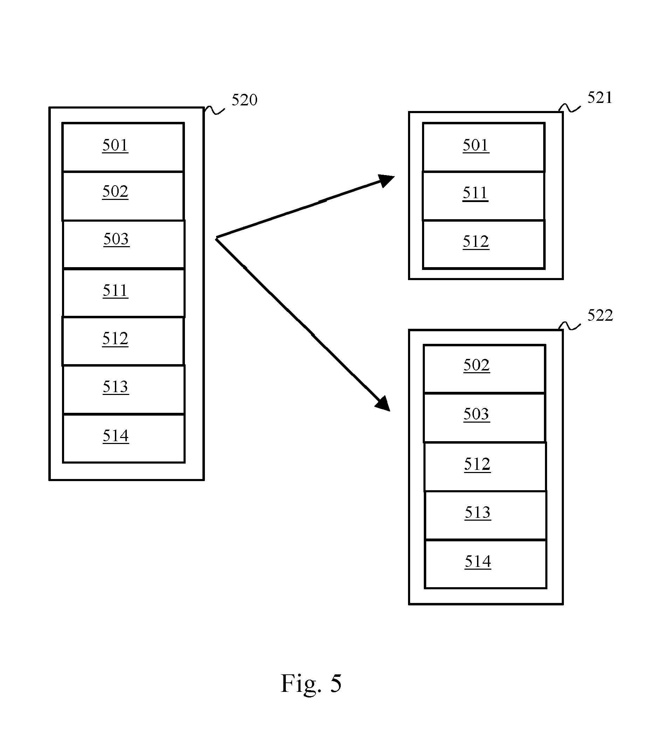

In a particular embodiment, applicable in the context of the first to third embodiments mentioned here above, the description analysis unit 102 is configured to generate plural proof obligations descriptions adapted to the proof obligations description outputs 103, 113, 123 from a single proof obligations description obtained from the proof obligations description input 101. The description analysis unit 102 is configured to limit the number of proof obligations in each description to a predefined maximum number *POₘₐₓ* of proof obligations. The description analysis unit 102 is then configured to select a set of at most *POₘₐₓ* proof obligations and then fill in the proof obligations description by selecting only logic expressions necessary for the definition of the selected proof obligations. The description analysis unit 102 is then configured to reiterate the process with another selection of proof obligations, until all proof obligations have been processed. In other words, the proof obligations are spread among the proof obligations descriptions according to a predefined maximum number of proof obligations per proof obligations description. The description analysis unit 102 is then configured to receive commands from the control unit 106 indicating when all proof obligations from a proof obligations description have been obtained, in order to switch a following proof obligations description. The description analysis unit 102 then updates the description outputs 103, 113, 123 upon receiving corresponding commands from the control unit 106. Further details are provided hereafter with regard to Fig. 4 and an example of plural proof obligations descriptions generated from a single proof obligations description is provided hereafter with regard to Fig. 5.

**Fig. 2** schematically represents a hardware platform that may implement the verification chain.

According to the shown architecture, the platform comprises the following components interconnected by a communications bus 206: a processor, microprocessor, microcontroller or CPU (*Central Processing Unit)* 200; a RAM (*Random-Access Memory)* 201; a ROM (*Read-Only Memory)* 202; an HDD (*Hard-Disk Drive*) 203, or any other device adapted to read information stored on storage means; a user interface 204 and a communication interface 205.

The user interface 204 allows interacting with user, in order to allow displaying results of the verification chain, to allow configuring the verification chain.

CPU 200 is capable of executing instructions loaded into RAM 201 from ROM 202, from HDD 203 or from an external storage means (not shown). After the platform has been powered on, CPU 200 is capable of reading instructions from RAM 201 and executing these instructions. The instructions form one computer program that causes CPU 200 to perform some or all of the steps of the algorithms described hereafter with regard to Figs. 3 and 4.

Any and all steps of the algorithms described hereafter with regard to Figs. 3 and 4 may be implemented in software by execution of a set of instructions or program by a programmable computing machine, such as a PC (*Personal Computer),* a DSP (*Digital Signal Processor)* or a microcontroller; or else implemented in hardware by a machine or a dedicated component, such as an FPGA (*Field-Programmable Gate Array)* or an ASIC *(Application-Specific Integrated Circuit).*

In addition, any and all units of the verification chain described hereinbefore with regard to Fig. 1 may be implemented in software by execution of a set of instructions or program by a programmable computing machine, such as a PC, a DSP or a microcontroller; or else implemented in hardware by a machine or a dedicated component, such as an FPGA or an ASIC.

**Fig. 3** schematically represents an algorithm for configuring automatic provers. The algorithm is performed by a processing device, such as the control unit 106 of the verification chain 100.

Fig. 3 is more particularly detailed when considering configuring the automatic provers with a processing limit corresponding to a processing timeout. It shall be understood that the same principles apply when the processing limit is a maximum number of proving steps that the automatic provers are allowed to perform, or when the processing limit is defined as a set of resources such as memory resources and/or CPU resources.

The processing device performs a first attempt to obtain at least one proof for at least one proof obligation with the automatic provers within a first processing limit. The processing device then selects, for each automatic prover, at least one proof obligation to be processed by said automatic prover, on the basis of a result of the first attempt with the automatic provers. The processing device then performs a second attempt to obtain at least one proof for the selected at least one proof obligation with the respective automatic provers within a second processing limit.

In a first embodiment, the processing device sets a first processing limit for the automatic provers to process the proof obligations. The processing device then checks the proofs obtained with the set first processing limit and sets a second processing limit, greater than the first processing limit, for the automatic provers to process remaining proof obligations. The processing limits are for instance processing timeouts, and the second processing timeout is longer than the first processing timeout.

In a second embodiment, the proof obligations are provided in sequence, and the processing device selects a second proof obligation for an automatic prover having obtained a proof for a first proof obligation during the first attempt, the second proof obligation being following in said sequence the first proof obligation. In this case, each automatic prover accepts one proof obligation at a time. Each automatic prover that hasn't obtained itself a proof switches to the next proof obligation in sequence, once the result of the first attempt allows considering said proof is obtained above a given confidence level. Furthermore, each automatic prover having obtained the proof during the first attempt switches to the next proof obligation in sequence. For instance, the proof has been obtained by at least one automatic prover or by at least a number of automatic provers above a given threshold.

In a third embodiment, a proof obligations description is input to each automatic prover, each proof obligations description describing each proof obligation to be proved by the automatic prover. The processing device removes, from at least one proof obligations description, each proof obligation that has been proved with the automatic provers during the first attempt. In this case, each automatic prover accepts one or more proof obligation at a time. Once a proof obligation is considered to be proved above a given confidence level, the proof obligation is removed from any description inputted to the automatic provers. Furthermore, the proof obligation is removed from the description inputted to each automatic prover having obtained the proof during the first attempt. The proving context of each automatic prover is thus simplified. The second attempt may be performed within a processing limit equal to the processing limit of the first attempt, or even shorter than the processing limit of the first attempt, as the proving context is reduced for the automatic provers. In a particular embodiment, the processing limit is increased from one attempt to another. This is further detailed hereafter with regard to steps S300 to S313.

The algorithm starts in a step S300. In a following step S301, the processing device sets a global timeout. The global timeout is for instance set to a predefined value. The global timeout aims at avoiding that the algorithm shown in Fig. 3 runs indefinitely. Another approach would be to fix a maximum number of attempts to obtain proofs.

In a following step S302, the processing device configures the automatic provers with a processing timeout. The processing timeout is for instance set to a predefined value.

In a following step S303, the processing device attempts to obtain proofs from the automatic provers within the set processing timeout. A proof obligations description is then input to each automatic prover.

In a following step S304, the processing device selects a proof obligation.

In a following step S305, the processing device associates with the selected proof obligation a flag indicating whether the proof obligation has been proved. In other words, the flag indicates whether at least one automatic prover generated a proof for the selected proof obligation. The processing device may in addition store an indication of which automatic prover succeeded in obtaining the proof. In other words, the processing device stores an identifier of each automatic prover that succeeded in obtaining the proof.

In a following step S306, the processing device associates with each proof obligation a confidence level. The confidence level may be representative of the number of automatic provers having proved the proof obligation. The confidence level may also be representative of identifiers of the automatic provers that succeeded in obtaining the proof.

In a following step S307, the processing device checks whether at least one proof obligation remains to be processed. If at least one proof obligation remains to be processed, the processing device repeats the step S304 and selects another proof obligation. Otherwise, the processing device performs a step S308.

In the step 308, the processing device checks the proof obligations according to their confidence level. The processing device compares the confidence level of the proof obligations with a predefined threshold. The processing device classifies the proof obligations according to whether their respective confidence level is lower or whether their respective confidence level is greater than or equal to the predefined threshold.

In a following step S309, the processing device checks whether the global timeout set in the step S301 expired. If the global timeout expired, the algorithm ends in a step S313; otherwise, the processing device performs a step S310.

In the step S310, the processing device checks whether it remains proof obligations that have not been proved or proof obligations for which their respective confidence level is lower than the predefined threshold. If such proof obligations remain, the processing device performs a step S311. Otherwise, the algorithm ends in the step S313.

In the step S311, the processing device increases the processing timeout and reconfigures the automatic provers accordingly. The newly set processing timeout is then longer than the previously set timeout.

In a following step S312, the processing device updates the proof obligations descriptions according to the progress in the proving process. When a proof obligation has been proved above a predefined confidence level, the proof obligation is removed by the processing device from the proof obligations descriptions. At least one proof obligations description may not require update, if the proof obligation has been already removed in a preceding iteration of the proving process. When a proof obligation has been proved by at least one automatic prover, but the proof is below the predefined confidence level, the proof obligation is removed by the processing device only from the proof obligations descriptions corresponding to the automatic prover(s) 104, 114, 124 having proved the proof obligation. Then, the processing device repeats the step S303.

This approach allows excluding from the remaining proving process proof obligations that can be proved by at least one automatic prover above a given confidence level, using a short processing timeout. Longer timeouts are then applied on a reduced set of proof obligations, thus reducing the global proving time. Indeed, some proof obligations can be more easily proved by some automatic provers than with others, although it might be difficult to *a priori* determine which proof obligations might be concerned.

In another embodiment, the processing device doesn't determine a confidence level for each proof obligation. Instead, the processing device reiterates the proving process for proof obligations that were not yet proved, and proof obligations descriptions are updated accordingly.

In yet another embodiment, the processing device reiterates the proving process for proof obligations that were not yet proved and for proof obligations that were proved by less than a predefined number of automatic provers. For instance, the processing device reiterates the proving process for proof obligations that were not yet proved and for proof obligations that were proved by only one automatic prover.

**Fig. 4** schematically represents an algorithm for generating proof obligations descriptions. The algorithm is performed by a processing device, such as description analysis unit 102 of the verification chain 100.

The algorithm starts in a step S401. In a following step S402, the processing device obtains a maximum number *POₘₐₓ* of proof obligations for the at least one automatic prover. This maximum number *POₘₐₓ* of proof obligations may be an upper limit of proof obligations that any automatic prover among the at least one automatic prover is capable to handle. This maximum number *POₘₐₓ* of proof obligations may be empirically defined as being the limit of proof obligations above which at least one automatic prover among the at least one automatic prover exceeds a predefined processing time threshold. In other words, for a number of proof obligations to be processed greater than *POₘₐₓ,* the time duration necessary to process the proof obligations exceeds said predefined processing time threshold.

In a following step S403, the processing device selects a set of at most *POₘₐₓ* proof obligations.

In a following step S404, the processing device selects formulas, axioms, lemmas or other logic expressions, according to the selected proof obligations. In other words, the processing device recreates the proving context of the selected proof obligations by selecting the formulas, axioms, lemmas or other logic expressions, used in the selected proof obligations.

In a following step S405, the processing device generates a proof obligations description for the selected proof obligations, the description including the selected formulas and being compliant with the at least one automatic prover. The proof obligations description can then be provided to the at least one automatic prover.

In a following step S406, the processing device checks whether at least one proof obligation remains to be processed. If at least one proof obligation remains to be processed, the processing device repeats the step S403 and selects a new set of at most *POₘₐₓ* proof obligations. The processing device selects a new set of *POₘₐₓ* proof obligations, unless less than *POₘₐₓ* proof obligations remain. In this latter case, the set of proof obligations consists in the remaining proof obligations. If no proof obligation remains to be processed, the algorithm ends in a step S407.

**Fig. 5** schematically represents an example of plural proof obligations descriptions 521, 522 generated from a single proof obligations description 520.

The proof obligations description 520 comprises three elements representing proof obligations 501, 502, 503. The proof obligations description 520 further comprises four elements representing formulas, axioms, lemmas or other logic expressions 511, 512, 513, 514 used in the definition of the proof obligations 501, 502, 503.

The proof obligations descriptions 521, 522 are generated from the proof obligations description 520, by executing the algorithm presented hereinabove with regard to Fig. 4.

Let's consider that *POₘₐₓ* equals 2.

Let's further consider that the proof obligation 501 is a logic expression based on formulas 511 and 512, the proof obligation 502 is a logic expression based on the formulas 512 and 513, and that the proof obligation 503 is a logic expression based on the formulas 513 and 514.

The proof obligations description 521 comprises one element representative of the proof obligation 501, as well as two elements respectively representative of the formulas 511 and 512.

The proof obligations description 522 comprises two elements respectively representative of the proof obligations 502 and 503, as well as three elements respectively representative of the formulas 512, 513 and 514.

Each proof obligations description 521, 522 therefore comprises at most *POₘₐₓ* proof obligations resulting from the proof obligations description 520, and the proof obligations of the proof obligations description 520 are spread among the proof obligations descriptions 521, 522. In addition, each proof obligations description 521, 522 is limited to the proving context of the proof obligations it contains.

## Claims

1. A method for configuring plural automatic provers for proving the correctness of plural proof obligations, the method being implemented by a device and **characterized in that** it comprises:
- performing a first attempt to obtain at least one proof for at least one proof obligation with the automatic provers within a first processing limit;
- selecting, for each automatic prover, at least one proof obligation to be processed by said automatic prover, on the basis of a result of the first attempt with the automatic provers; and
- performing a second attempt to obtain at least one proof for the selected at least one proof obligation with the respective automatic provers within a second processing limit.

2. The method according to claim 1, **characterized in that** said second processing limit is greater than the first processing limit.

3. The method according to any one of claims 1 and 2, **characterized in that**, said plural proof obligations being provided in sequence, selecting comprises:
- selecting a second proof obligation for an automatic prover having obtained a proof for a first proof obligation, the second proof obligation being following in said sequence the first proof obligation.

4. The method according to any one of claims 1 and 2, **characterized in that**, a proof obligations description being input to each automatic prover, each proof obligations description describing each proof obligation to be proved by the automatic prover, selecting comprises:
- removing, from at least one proof obligations description, each proof obligation that has been proved with the automatic provers during the first attempt.

5. The method according to any one of claims 1 to 4, **characterized in that** it comprises:
- associating a confidence level with each proof obligation that has been proved during the first attempt;
and **in that** selecting comprises:
- selecting each proof obligation associated with a confidence level below than a predefined threshold.

6. The method according to claim 5, **characterized in that** said confidence level is determined on the basis of a number of automatic provers having proved the proof obligation.

7. The method according to any one of claims 5 and 6, **characterized in that** said confidence level is determined on the basis of an identification of automatic provers having proved the proof obligation.

8. The method according to any one of claims 5 to 7, **characterized in that**, a proof obligations description being input to each automatic prover, each proof obligations description describing each proof obligation to be proved by the automatic prover, selecting comprises:
- removing each proof obligation that has been proved with the automatic provers during the first attempt from each proof obligations description to be input to an automatic prover having proved said proof obligation during the first attempt; and
- removing each proof obligation that is associated with a confidence level above said predefined threshold from each proof obligations description.

9. The method according to any one of claims 4 to 8, **characterized in that**, a proof obligations description being input to each automatic prover, it comprises beforehand spreading, according to a predefined maximum number of proof obligations per proof obligations description, the plural proof obligations among plural proof obligations descriptions.

10. The method according to any one of claims 1 to 9, **characterized in that** said processing limits are processing timeouts.

11. The method according to any one of claims 1 to 9, **characterized in that** said processing limits are maximum numbers of proving steps or maximum amount of processing resources.

12. A computer program **characterized in that** it comprises program code instructions which can be loaded in a programmable device for implementing the method according to any one of claims 1 to 11, when the program code instructions are run by the programmable device.

13. Information storage means, **characterized in that** they store a computer program comprising program code instructions which can be loaded in a programmable device for implementing the method according to any one of claims 1 to 11, when the program code instructions are run by the programmable device.

14. A device for configuring plural automatic provers for proving the correctness of plural proof obligations, **characterized in that** it comprises:
- means for performing a first attempt to obtain at least one proof for at least one proof obligation with the automatic provers within a first processing limit;
- means for selecting, for each automatic prover, at least one proof obligation to be processed by said automatic prover, on the basis of a result of the first attempt with the automatic provers; and
- means for performing a second attempt to obtain at least one proof for the selected at least one proof obligation with the respective automatic provers within a second processing limit.

15. The device according to claim 14, **characterized in that** said second processing limit is greater than the first processing limit.
